# EUROPÄISCHE PATENTSCHRIFT

(11) **EP 0 306 713 B1**
(45) Veröffentlichungstag und Bekanntmachung des Hinweises auf die Patenterteilung: **31.03.1993**
(21) Anmeldenummer: 88112867.2
(22) Anmeldetag: 08.08.1988
(51) Int. Cl.: H04B 7/185

(54) **Verfahren und Anordnung zur Aufbereitung von Daten**
Method and device for data processing
Procédé et dispositif pour le traitement de données

(30) Priorität: 11.09.1987 DE 3730547
(43) Veröffentlichungstag der Anmeldung: 15.03.1989
(73) Patentinhaber: ANT Nachrichtentechnik GmbH, D-71522 Backnang (DE)
(72) Erfinder: Heichler, Johannes, Dipl.-Ing., D-7157 Murrhardt 3 (DE)

(56) Entgegenhaltungen:
- EP-A- 0 134 101
- EP-A- 0 208 537
- US-A- 4 483 012
- IEEE GLOBAL TELECOMMUNICATION CONFERENCE, 1983, Globecom 83, San Diego, US; Conference Record 2, Seiten 1050-1053
- IEEE JOURNAL ON SELECTED AREAS IN COMMUNICATIONS, vol. SAC-5, no. 4, May 1987, Seiten 724-748, New York, US; W.W. Wu et al.: "Coding for Satellite Communication"

## Beschreibung

Die Erfindung geht aus von einem Verfahren zur Aufbereitung von Daten gemäß dem Oberbegriff des Patentanspruchs 1.

Bei der Aufbereitung von Daten, die einer Differenz- und einer Faltungscodierung unterzogen werden ist es bekannt diese Daten, insbesondere bei hohen Datenraten, in Teildatenströme aufzuteilen. Beim TDRSS (Tracking and Data Relay Satellite System)-System werden die Teildatenströme einzeln faltungscodiert und mittels Multiplexer zu ineinander verschachtelten Ausgangsdatenströmen zusammengefaßt, die dann einem QPSK-Modulator für die Übertragung zugeführt werden. Auf der Empfangsseite erfolgt dann eine entsprechende Rückwandlung (IEEE Global Telecommunication Conference, Globecom 83, San Diego, USA, Conference Record 2, Seiten 1050-1053). Zur korrekten Synchronisierung muß entweder ein festes Datenübertragungsformat vorliegen, oder eine Zusatzinformation übertragen werden, beispielsweise eine hinzugefügte PN-Sequenz (Globecom 83, s.o.).

Aufgabe der Erfindung ist es, ausgehend vom Oberbegriff des Patentanspruchs 1, ein Verfahren aufzuzeigen, welches Weder an ein festes Datenübertragungsformat gebunden ist noch Zusatzinformation benötigt. Außerdem soll eine Anordnung zum Durchführen eines solchen Verfahrens angegeben werden. Diese Aufgabe wird bezüglich des Verfahrens durch die Merkmale des Patentanspruchs 1 und bezüglich der Anordnung durch die Merkmale des Patentanspruchs 5 gelöst. Die Patentansprüche 2 bis 4 betreffen Ausgestaltungen des Verfahrens und die Patentansprüche 6 bis 8 Ausgestaltungen der Anordnung.

Das Verfahren nach der Erfindung weist folgende Vorteile auf:
Die Bitfehlerrate ist geringer als bei einem herkömmlichen TDRSS-System, da die Differenzdecodierung unmittelbar nach der Faltungdecodierung mittels eines Viterbi-Decoders ohne Zwischenschaltung eines Multiplexers erfolgen kann. Dies beruht auf folgender Überlegung: Hinter einem einzelnen Viterbi-Decoder sind die Bitfehlerraten geringer als hinter einem gemultiplexten Verbund solcher Stufen. Da ein Differenz-Decoder die Bitfehlerrate vervielfacht, ist sie bei einem herkömmlichen TDRSS-System größer, wenn man berücksichtigt, daß der Viterbi-Decoder Burststörungen ausgibt, die der Differenz-Decoder nicht so stark bewertet wie Einzelstörungen. Diese treten auf, wenn man die Viterbi-Decoder für jeden Teildatenstrom mit einem Multiplexer wie beim herkömmlichen TDRSS-System abtastet und anschließend differenzdecodiert.

Es sind keine speziellen Synchronisationsmaßnahmen notwendig, nicht einmal eine Knotensynchronisierung (node synchronization).

Phasenmehrdeutigkeiten können ohne spezielle Maßnahmen erkannt werden und zwar von jedem Decoder eines Teildatenstromes. Hat ein Decoder die richtige Phasenlage erkannt, kann er diese Information den Decodern der anderen Teildatenströme mitteilen, was zu einer schnelleren Synchronisierung führt.

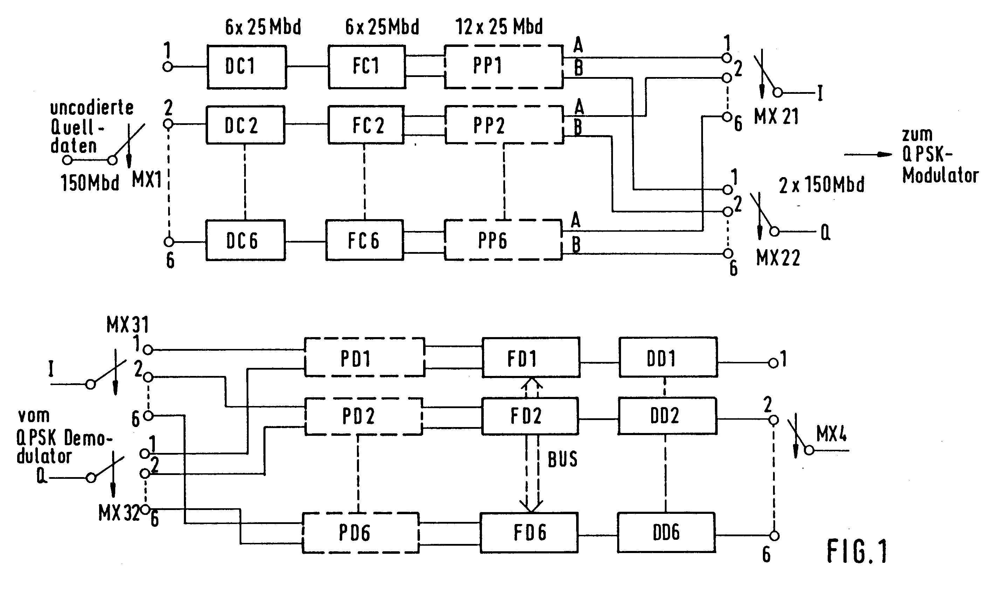

Anhand der Zeichnungen wird ein Ausführungsbeispiel der Erfindung nun näher erläutert. Es zeigen
- Figur 1: ein Blockschaltbild zum Durchführen des Verfahrens nach der Erfindung,
- Figur 2: den Aufbau eines Differenz-Coders,
- Figur 3: den Aufbau eines Differenz-Decoders,
- Figur 4: ein Blockschaltbild für eine Parallel-Punktierung,
- Figur 5: ein Blockschaltbild für eine Serien-Punktierung
Wie in Figur 1 dargestellt ist, werden uncodierte Quelldaten als Eingangsdaten mit einer Datenrate von beispielsweise 150 Mbd zu einem Demultiplexer MX1 geführt, der den uncodierten Quelldatenstrom in 6 parallele Teildatenströme mit einer Datenrate von 25 Mbd aufteilt. Jeder Teildatenstrom wird jeweils für sich differenzcodiert - mittels der Differenz-Coder DC1... DC6 - und anschließend faltungscodiert - mittels der Faltungs-Coder FC1...FC6. Gegebenenfalls werden die Ausgangsdatenströme der Faltungs-Coder FC1...FC6 zur Erhöhung der Coderate über Code-Punktierer PP1...PP6 geführt. Im Ausführungsbeispiel gemäß Figur 1 werden Faltungscoder verwendet, die zwei Ausgangsbitströme liefern, nämlich die I und Q Kanäle - phasalen Komponenten - für die QPSK-Übertragung. Prinzipiell sind natürlich auch Faltungscoder verwendbar mit mehr als zwei Ausgangsbitströmen sowie eine andere Art der Übertragung,z.B. 8-PSK. Die beiden Ausgangsbitströme jedes Faltungscoders werden auf zwei verschiedene Multiplexer MX21 und MX 22 geführt und zwar so, daß jeweils ein Ausgangsbitstrom A erster Art jedes Faltungscoders nur auf den Multiplexer MX21 und ein Ausgangsbitstrom B zweiter Art nur auf den Multiplexer MX22 geführt wird. Der Multiplexer MX21 fügt alle Ausgangsbitströme A erster Art seriell zu einem Ausgangsdatenstrom I und der Multiplexer MX22 alle Ausgangsbitströme B zweiter Art seriell zu einem Ausgangsdatenstrom Q zusammen. Die Datenströme I und Q als phasale Komponenten bei QPSK-Modulation weisen jeweils eine Bitrate von 150 Mbd auf. Durch diese Beschaltung der Multiplexer MX21 und MX22 ist gewährleistet, daß sowohl der Datenstrom I als auch der Datenstrom Q aus allen Faltungscodedatenströmen zusammengesetzt ist und die Vorteile der Erfindung, wie geringe Bitfehlerrate Phasenmehrdeutigkeitserkennung und schnelle Synchronisierung ohne Zusatzinformation oder Rahmenstruktur voll zur Wirkung kommen. Die Datenströme I und Q werden zur Übertragung an einen QPSK-Modulator weitergeleitet.

Empfangsseitig werden die mittels eines QPSK-Demodulators gewonnenen phasalen Komponenten I und Q entsprechend der senderseitigen Aufbereitung wieder auf sechs Parallelzweige aufgeteilt. Der Demultiplexer MX 31 verteilt den empfangsseitigen Datenstrom I auf 6 Parallelzweige und der Demultiplexer MX32 den Datenstrom Q auf ebenfalls 6 Parallelzweige. Die Datenrate des I und Q Datenstroms beträgt 150 Mbd und die Datenrate am Ausgang der beiden Multiplexer 12x25 Mbd. Immer 2 Parallelzweige, von denen einer aus dem I Datenstrom und einer aus dem Q Datenstrom stammt, werden auf die beiden Eingänge eines Faltungsdecoders, FD1...FD6, geschaltet. Da jeder dieser Faltungsdecoder nur einen Ausgang besitzt liegen Faltungsdecoder mit einer Rate R = 1/2 vor. Jeder Ausgangsdatenstrom eines der 6 Faltungsdecoder FD1...FD6 mit der Bitrate 25 Mbd ist zu einem Differenz-Decoder, DD1...DD6 geführt. Die Ausgangsdatenströme der 6 Differenz-Decoder werden durch einen Multiplexer MX4 seriell aneinandergefügt so daß ein dekodierter Empfangsdatenstrom von 150 Mbd zur Verfügung steht.

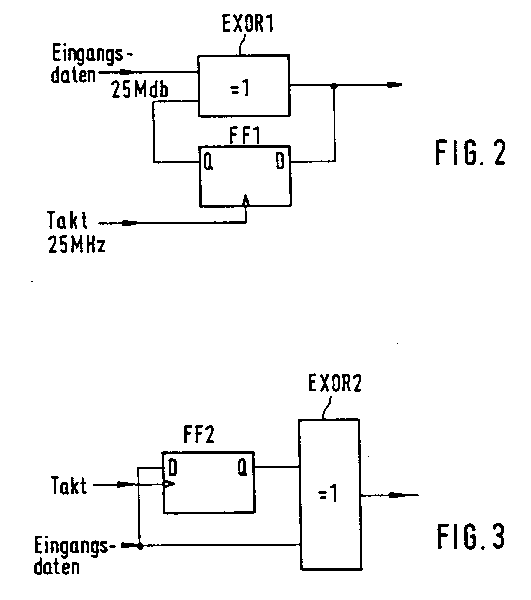

Nachfolgend werden nun die Einzelbaugruppen des Übersichtsblockschaltbildes nach Figur 1 näher erläutert. Figur 2 zeigt einen Differenz-Coder wie er für alle Teildatenströme von 25 Mbd vorgesehen ist. Der Eingangsdatenstrom wird einem Eingang eines Exclusiv-ODER Gatters EXOR 1 zugeführt. Der Ausgang dieses Exclusiv-ODER-Gatters EXOR1,welcher den Ausgang des Differenz-Coders darstellt, ist über ein D-Flip-Flop FF1, welches als Verzögerungselement wirkt, auf den zweiten Eingang des Gatters EXOR1 rückgeführt. Die Taktung des Flip-Flops FF1 erfolgt mit einem Taktsignal von 25 MHz. Den entsprechenden empfangsseitigen Differenz-Decoder zeigt Figur 3. Das Ausgangssignal jedes Faltungsdecoders gelangt als Eingangssignal für die Differenz-Decodierung auf den ersten Eingang eines Exclusiv-ODER Gatters EXOR2 sowie über ein D-Flip-Flop FF2 verzögert auf den zweiten Eingang dieses Gatters. Am Ausgang jedes Exclusiv-ODER Gatters EXOR2 steht ein decodierter Teildatenstrom zur Verfügung, welcher mittels Multiplexer MX4 zum empfangsseitigen Gesamtdatenstrom zusammengefügt wird. Die Taktung des Flip-Flops FF2 erfolgt wie auf der Sendeseite mit einem 25 MHz Taktsignal.

Als Faltungscoder FC1...FC6 und Faltungsdecoder FD1...FD6 können beliebige bekannte Anordnungen verwendet werden. Besonders geeignet sind die aus DE-A-3600905 bekannten Anordnungen, da der dortige Viterbi-Decoder Echtzeitverarbeitung gestattet.

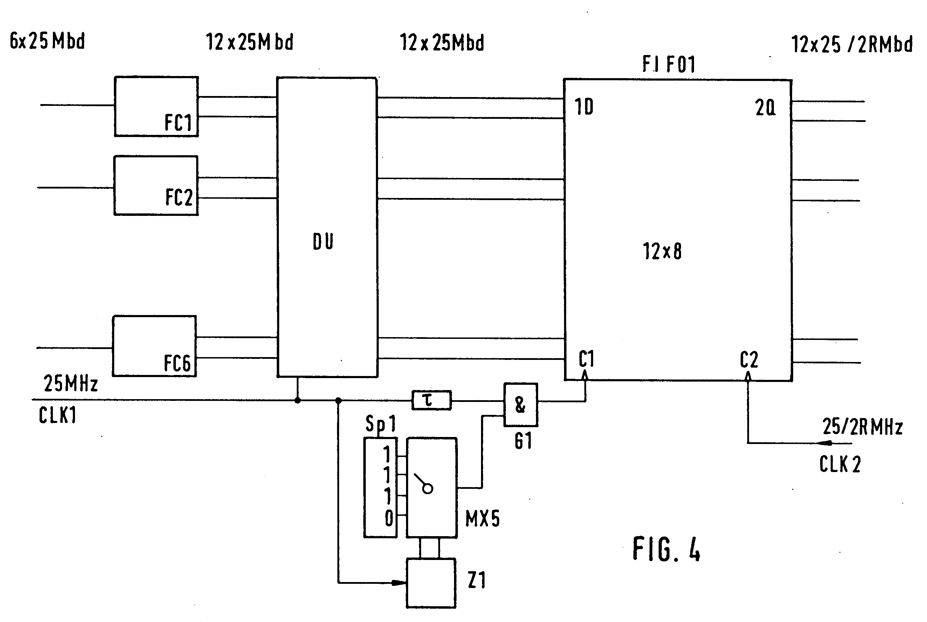

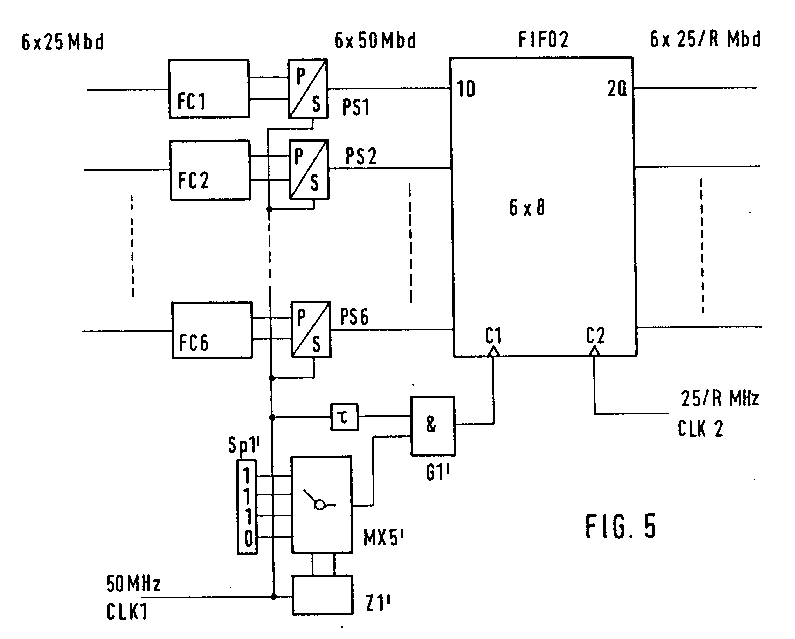

Falls eine Codepunktierung gewünscht oder erforderlich ist, kann diese vorteilhafterweise nach der Faltungscodierung vorgenommen werden. Es kann entweder eine Parallel-Punktierung oder eine Serien-Punktierung vorgenommen werden. Figur 4 zeigt ein Blockschaltbild für eine Parallel-Punktierung und Figur 5 ein Blockschaltbild für eine Serien-Punktierung. Die faltungscodierten Teildatenströme werden im Falle der Parallel-Punktierung zuerst einer Datenumordnungsstufe DU zugeführt, beispielsweise bestehend aus Flip-Flops zur Anpassung der Teildatenströme an einen FIFO (first in first out)-Speicher FIFO1 im Format 12x8. Als FIFO-Speicher FIFO1 kann beispielsweise der integrierte Schaltkreis TDC 1030 der Firma TRW verwendet werden. Als Schreibtakt erhält dieser FIFO-Speicher einen Takt der für die auszulassenden - punktierten - Bits eine Unterbrechung aufweist. Diese Schreibtaktunterbrechung wird durch ein &-Gatter G1 erreicht, dem zum einen ein kontinuierlicher Takt CLK1 zugeführt wird und zum anderen das Ausgangssignal eines Multiplexers MX5. Dieser Multiplexer MX5 schaltet das in einem Speicher Sp1 abgelegte Punktiermuster (Deleting map) in Form einer 1-0 Folge mit der Breite P Bits auf das &-Gatter G1 durch. Sobald der Multiplexer MX5 von der Deleting Map eine 0 auf das Gatter G1 durchschaltet, wird der Schreibtakt unterbrochen. Der Multiplexer MX4 wird in seiner Fortschaltung über einen Zähler Z1 vom Takt CLK1 gesteuert. Zur Unterdrückung von Spikes ist das Gatter G1 nicht direkt mit dem Takt CLK1 beaufschlagt, sondern mit einem durch ein Verzögerungsglied etwas verzögerten Takt, der die Umschaltzeiten des Multiplexers MX5 berücksichtigt. Der Lesetakt CKL2 für den Parallel-Punktierer ist kontinuierlich. Die grundsätzliche Funktion des Punktierers ist ähnlich wie in Conf. Proc. 6th Internat. Conf. on Digital Satellite Communications, Seite XII-26, Figur 5, jedoch ist die Verarbeitung parallel und damit bei gleicher Taktrate der doppelte Datendurchsatz erreichbar.

Der empfangsseite Depunktierer PD1 - nicht dargestellt - ist entsprechend aufgebaut, nur wird hier anstatt dem Schreibtakt der Lesetakt des FIFO-Speichers unterbrochen. Die Lesetaktunterbrechung erfolgt mit den gleichen Baugruppen, also &-Gatter, Multiplexer, Speicher für die Deleting map und Zähler. Hinter dem FIFO-Speicher befindet sich jedoch zusätzlich ein Multiplexer der in den Lesepausen metrikneutrale Auffülldaten sogenannte "Dummy Bits" einblendet. Bei der Serienpunktierung gemäß Fig. 5 ist jedem Faltungscoder ein Parallel-Serienwandler PS1...PS6 nachgeschaltet, der die beiden Ausgangsbitströme jedes Faltungscoders mit der Bitrate 25 Mbd in einen seriellen Datenstrom der Bitrate 50 Mbd umwandelt. Der FIFO-Speicher FIFO2 ist hier vom Format 6x8. Die Schreibtaktaufbereitung für diesen FIFO-Speicher FIFO2 erfolgt wie beim Ausführungsbeispiel gemäß Figur 4 ebenso die Depunktierung.

Die in Figur 1 gezeigten Multiplexer bzw. Demultiplexer MX1, MX21, MX22, MX31,MX32 und MX4 bestehen im einfachsten Fall aus Schieberegistern, die im Falle der Datenaufteilung einen Dateneingang an der ersten Speicherzelle aufweisen und Parallelausgänge für jede Speicherzelle besitzen und im Falle der Datenzusammenfassung Paralleleingänge für jede Speicherzelle und einen Datenausgang an der letzten Speicherzelle aufweisen. Zu beachten ist nur, daß die Schieberichtung und -geschwindigkeit der Schieberegister auf der Sendeseite mit der Schieberichtung und -geschwindigkeit auf der Empfangsseite übereinstimmt.

Es können alle Codierstufen wie Differenz-Coder, Faltungscoder und Punktierer in einer integrierten Schaltung, beispielsweise in CMOS Technik realisiert werden.

Um die Information über eine richtig erkannte Phasenlage eines Faltungsdecoders möglichst schnell an die anderen Faltungsdecoder weiterzuleiten ist zwischen den Faltungsdecodern FD1...FD6 ein Datentausch BUS vorgesehen (Figur 1).

## Patentansprüche

1. Verfahren zur Aufbereitung von Daten für Übertragungszwecke, wobei die Daten einer Differenzcodierung (DC) und einer Faltungscodierung (FC) unterzogen werden, wobei ein Eingangsdatenstrom auf mehrere Teildatenströme (1...6) mit langsamerer Verarbeitungsgeschwindigkeit aufgeteilt wird und wobei diese Teildatenströme nach der Codierung zu mindestens zwei aus den Teildatenströmen zusammengesetzten phasalen Komponenten für die Übertragung zusammengefaßt werden (I,Q), dadurch gekennzeichnet, daß die Teildatenströme jeweils für sich getrennt differenzcodiert (DC1...DC6) und anschließend faltungscodiert (FC1...FC6) werden, daß die phasalen Komponenten (I,Q) für die Übertragung jeweils aus Faltungscodedatenströmen jedes Teildatenstromes (A,B) zusammengesetzt werden, und daß Daten aus allen phasalen Komponenten bei der Faltungsdecodierung jedes Teildatenstromes (FD1...FD6) herangezogen werden.

2. Verfahren nach Anspruch 1, dadurch gekennzeichnet, daß die faltungscodierten Teildatenströme sendeseitig codepunktiert (PP) werden und empfangsseitig entsprechend depunktiert (PD) werden.

3. Verfahren nach Anspruch 2, dadurch gekennzeichnet, daß die Codepunktierung und die Depunktierung parallelverarbeitend vorgenommen wird.

4. Verfahren nach einem der Ansprüche 1 bis 3, dadurch gekennzeichnet, daß zur empfangsseitigen Faltungsdecodierung und Differenzdecodierung wiederum Teildatenströme gebildet werden, daß jeweils mindestens zwei dieser Teildatenströme einer gemeinsamen Faltungsdecodierung unterzogen werden, wobei die Zuordnung der Teildatenströme einer Faltungsdecodierung so erfolgt, daß bei der Faltungsdecodierung die Daten aus allen phasalen Komponenten der Demodulation herangezogen werden.

5. Anordnung zum Durchführen des Verfahrens nach einem der Ansprüche 1 bis 4, gekennzeichnet durch
- einen ersten Demultiplexer (MX1) zur Bildung von Teildatenströmen aus einem Eingangsdatenstrom,
- Differenz-Codern (DC1...DC6) zur Verarbeitung jedes Teildatenstromes,
- Faltungs-Codern (FC1...FC6) zur Verarbeitung der differenzcodierten Daten jedes Teildatenstromes,
- mindestens zwei zweiten Multiplexern (MX21, MX22) zur Bildung von aus den Faltungscodedatenströmen zusammengesetzten phasalen Komponenten, wobei die Eingänge dieser Multiplexer (MX 21, MX22) derart mit den Ausgängen der Faltungs-Coder (FC1...FC6) verbunden sind, daß die phasalen Komponenten jeweils aus Faltungscodedatenströmen jedes Teildatenstromes zusammengesetzt sind.

6. Anordnung zum Durchführen des Verfahrens nach einem der Ansprüche 1 bis 4, gekennzeichnet durch
- mindestens zwei dritten Multiplexern (MX31, MX32) zur Aufteilung der übertragenen phasalen Komponenten in Teildatenströme,
- Faltungsdecodern (FD1,...FD6) für die Teildatenströme, die derart mit den Ausgängen der dritten Multiplexer (MX31, MX32) verbunden sind, daß jede Faltungsdecodierung aus allen phasalen Komponenten erfolgt,
- Differenz-Decodern (DD1,...DD6) die den Faltungsdecodern (FD1,...FD6) jeweils nachgeschaltet sind,
- einem vierten Multiplexer (MX4) zur Zusammenfassung aller decodierten Teildatenströme.

7. Anordnung nach Anspruch 5, gekennzeichnet durch Parallelpunktierer (PP1,...PP6), die den Faltungscodern (FC1,...FC6) jeweils nachgeschaltet sind.

8. Anordnung nach Anspruch 6, gekennzeichnet durch Paralleldepunktierer (PD1,...PD6), die den Faltungsdecodern (FD1,...FD6) jeweils vorgeschaltet sind.

9. Anordnung nach einem der Ansprüche 6 oder 8, gekennzeichnet durch
einen Datenbus (BUS) zwischen den Faltungsdecodern (FD1,...FD6) zur Weitergabe einer richtig erkannten Phasenlage durch einen Faltungsdecoder an alle anderen Faltungsdecoder.

## Claims

1. A method of processing data for transmission purposes, wherein the data are subjected to difference coding (DC) and convolutional coding (FC) and an input data stream is subdivided into a plurality of data substreams (1, ..., 6) of a slower processing speed and, after coding, said data substreams are combined for transmission into at least two phase components (I, Q) combined from the data substreams, characterised in that the data substreams are each difference coded (DC1, ..., DC6) separately and are thereafter coded convolutionally (FC1, ..., FC6); for transmission, the phase components (I, Q) are composed of the convolutional code data streams of each data substream (A, B); and the data of all phase components are utilised for the convolutional decoding of each data substream (FD1, ..., FD6).

2. A method according to claim 1, characterised in that the convolutionally coded data substreams are code punctured (PP) at the transmitting end and are correspondingly depunctured (DP) at the receiving end.

3. A method according to claim 2, characterised in that the code puncturing and depuncturing are performed by parallel processing.

4. A method according to one of claims 1 to 3, characterised in that data substreams are again formed for convolutional decoding and difference decoding at the receiving end; at least two of these data substreams are subjected to joint convolutional decoding, with the association of the data substream of one convolutional decoding process being effected in such a manner that the data from all phase components of the demodulation are utilised for the convolutional decoding.

5. An arrangement for implementing the method defined in one of claims 1 to 4, characterised by:
- a first demultiplexer (MX1) for forming data substreams from an input data stream;
- difference coders (DC1, ..., DC6) for processing each data substream;
- convolutional coders (FC1, ..., FC6) for processing the difference coded data of each data substream;
- at least two second multiplexers (MX21, MX22) for forming phase components composed of convolutional code data streams, with the inputs of said multiplexers (MX21, MX22) being connected with the outputs of the convolutional coders (FC1, ..., FC6) in such a manner that each one of the phase components is a combination of the convolutional code data streams of each data substream.

6. An arrangement for implementing the method according to one of claims 1 to 4, characterised by:
- at least two third multiplexers (MX31, MX32) for dividing the transmitted phase components into data substreams;
- convolutional decoders (FD1, ..., FD6) for the data substreams which are connected with the outputs of the third multiplexers (MX31, MX32) in such a manner that each convolutional decoding is effected from all phase components;
- difference decoders (DD1, ..., DD6) each connected subsequent to a convolutional decoder;
- a fourth multiplexer (MX4) for combining all decoded data substreams.

7. An arrangement according to claim 5, characterised by parallel puncturers (PP1, ..., PP6) that are connected to the outputs of the respective convolutional coders (FC1, ..., FC6).

8. An arrangement according to claim 6, characterised by parallel depuncturers (PD1, ..., PD6) that are connected to the inputs of the respective convolutional decoders (FD1, ..., FD6).

9. An arrangement according to one of claims 6 or 8, characterised by a data bus (BUS) that is provided between the convolutional decoders (FD1, ..., FD6) for forwarding a correctly detected phase position from one convolutional decoder to all other convolutional decoders.

## Revendications

1. Procédé de traitement de données à des fins de transmission, dans lequel les données sont soumises à un codage de différence (DC) et à un codage par convolution (FC), un flux de données d'entrée est partagé en plusieurs flux partiels de données (1...6) à vitesse de traitement plus lente et, après le codage, ces flux partiels de données sont regroupés en au moins deux composantes phasiques (I, Q) composées à partir des flux partiels de données, aux fins de transmission, caractérisé par le fait que les flux partiels de données sont soumis séparément, chacun pour soi, à un codage de différence (DC1...DC6) puis à un codage par convolution (FC1...FC6), par le fait que les composantes phasiques (I, Q) pour la transmission sont composées chacune de flux de données de code de convolution de chaque flux partiel de données (A, B), et par le fait que l'on fait appel à toutes les composantes phasiques lors du décodage de convolution de chaque flux partiel de données (FD1...FD6).

2. Procédé selon revendication 1, caractérisé par le fait que les flux partiels de données codés par convolution sont codés-pointillés (PP) côté émission et sont dépointillés (PD) de manière correspondante côté réception.

3. Procédé selon revendication 2, caractérisé par le fait que le codage-pointillage et le dépointillage sont effectués en traitement parallèle.

4. Procédé selon l'une des revendications 1 à 3, caractérisé par le fait que, pour le décodage de convolution et de différence côté réception, on forme de nouveau des flux partiels de données, par le fait qu'au moins deux de ces flux partiels de données sont à chaque fois soumis à un décodage de convolution commun, la conjugaison des flux partiels de données d'un décodage de convolution étant faite de manière telle que, lors du décodage de convolution, il est fait appel aux données de toutes les composantes phasiques de la démodulation.

5. Dispositif de mise en oeuvre du procédé selon l'une des revendications 1 à 4, caractérisé par
- un premier démultiplexeur (MX1), pour former des flux partiels de données à partir d'un flux de données d'entrée;
- des codeurs de différence (DC1...DC6), pour traiter chaque flux partiel de données;
- des codeurs par convolution (FC1...FC6) pour traiter les données codées en différence de chaque flux partiel de données;
- au moins deux deuxièmes multiplexeurs (MX21, MX22) pour former des composantes phasiques composées des flux de données de code de convolution, les entrées de ces multiplexeurs (MX21, MX22) étant reliées aux sorties des codeurs par convolution (FC1...FC6) de façon telle que les composantes phasiques soient composées chacune à partir de flux de données de code de convolution de chaque flux partiel de données.

6. Dispositif de mise en oeuvre du procédé selon l'une des revendications 1 à 4, caractérisé par
- au moins deux troisièmes multiplexeurs (MX31, MX32), pour répartir dans des flux partiels de données les composantes phasiques transmises;
- des décodeurs de convolution (FD1, ...FD6) pour les flux partiels de données, lesquels décodeurs sont reliés aux sorties des troisièmes multiplexeurs (MX31, MX32) de manière telle que chaque décodage de convolution s'effectue à partir de toutes les composantes phasiques;
- des décodeurs de différence (DD1, ...DD6) qui sont respectivement en aval des décodeurs de convolution (FD1, ...FD6);
- un quatrième multiplexeur (MX4) pour le regroupement de tous les flux partiels de données décodés.

7. Dispositif selon revendication 5, caractérisé par des pointilleurs parallèles (PP1,...PP6) qui sont respectivement en aval des codeurs par convolution (FC1, ...FC6).

8. Dispositif selon revendication 6, caractérisé par des dépointilleurs parallèles (PD1,...PD6) qui sont respectivement en amont des décodeurs de convolution (FD1,...FD6).

9. Dispositif selon l'une des revendications 6 ou 8, caractérisé par un bus de données (BUS) entre les décodeurs de convolution (FD1,...FD6), pour la transmission d'une position de phase correctement identifiée, par un décodeur de convolution, à tous les autres décodeurs de convolution.
